(19) Europäisches Patentamt
European Patent Office
Office européen des brevets

(11) Veröffentlichungsnummer: **0 070 253**
**B1**

(12) # EUROPÄISCHE PATENTSCHRIFT

(45) Veröffentlichungstag der Patentschrift: **04.09.85**

(21) Anmeldenummer: **82810285.5**

(22) Anmeldetag: **05.07.82**

(51) Int. Cl.⁴: **G 03 C 1/70**, G 03 C 1/68, C 08 F 2/48, C 08 F 20/32, C 08 F 20/36, C 08 F 22/22, C 08 G 59/22

(54) **Photopolymerisierbare Harze.**

(30) Priorität: **09.07.81 GB 8121172**
**03.04.82 GB 8209955**

(43) Veröffentlichungstag der Anmeldung: **19.01.83 Patentblatt 83/3**

(45) Bekanntmachung des Hinweises auf die Patenterteilung: **04.09.85 Patentblatt 85/36**

(84) Benannte Vertragsstaaten: **CH DE FR GB IT LI NL SE**

(56) Entgegenhaltungen:
**GB - A - 1 367 207**
**GB - A - 1 399 135**
**GB - A - 1 521 933**

(73) Patentinhaber: **CIBA-GEIGY AG, Postfach, CH-4002 Basel (CH)**

(72) Erfinder: **Hathaway, Roderick Donald, 65, Sedgwick Street, Cambridge CB1 3AJ (GB)**
Erfinder: **Irving, Edward, Dr., 41, Swaffham Road, Burwell Cambridge CB5 0AN (GB)**
Erfinder: **Waterhouse, John Sidney, Dr., 9, Daws Close, Cherry Hinton Cambridge CB1 4LE (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 070 253 B1

ACTORUM AG

**Beschreibung**

Die vorliegende Erfindung betrifft bei Belichtung mit aktinischer Strahlung polymerisierende Harze, Methoden zu deren Herstellung und die Polymerisation solcher mit Wasser gemischten Harze mittels aktinischer Strahlung, Schichtträger mit einem solchen darauf aufgebrachten Harz im polymerisierbaren Zustand und ein mittels aktinischer Strahlung polymerisiertes Harz tragende Substrate.

Bei Belichtung mit aktinischer Strahlung der Polymerisation fähige Substanzen werden als Oberflächenbeschichtungen verwendet, z.B. auf Metallen, Papier und Karton (d.h. etwa 0,1 bis 0,5 mm dicke, zum Aufbau von Faltschachteln verwendete Kartonpappe). Der Vorteil der Verwendung aktinischer Strahlung liegt darin, dass der Energieverbrauch im allgemeinen niedriger ist, als wenn die Substanzen durch Hitzeeinwirkung polymerisiert werden müssten. Dabei weithin verwendete Substanzen sind das Addukt von Acrylsäure oder Methacrylsäure mit dem Diglycidyläther von Bisphenol A, d.h. 2,2-Bis-[4-(3-acryloyloxy-2-hydroxypropoxy)-phenyl]-propan oder dessen Methacryloylhomolog. Die Viskosität der diese Addukte enthaltenden Formulierungen ist jedoch im allgemeinen zu hoch für leichten Auftrag, und deshalb werden niedermolekulare photopolymerisierbare Acrylate, wie Propylenglykoldiacrylat und Glycerintriacrylat miteingebaut.

Die Verwendung flüchtiger, niedermolekularer Acrylatester in solchen Formulierungen ist jedoch häufig aus Toxizitätsgründen unerwünscht, und es besteht daher ein Bedarf für mittels aktinischer Strahlung polymerisierbare, als Oberflächenbeschichtungen verwendbare Harze, die aber keine niedermolekularen Acrylatester enthalten.

Es wurde nun gefunden, dass man durch Verwendung gewisser neuartiger vorverlängerter Harze den oben genannten Bedarf zumindest weitgehend erfüllen kann.

In der britischen Patentschrift Nr. 1 521 933 der Anmelderin wurden Harze beschrieben, die vor Belichtung mit aktinischer Strahlung wasserlöslich sind, aber bei Belichtung mit aktinischer Strahlung polymerisieren und wasserunlöslich werden, wobei diese Harze der Formel

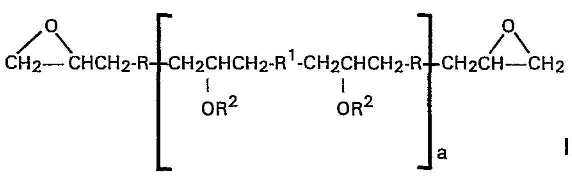

I

entsprechen, worin a eine ganze Zahl vom Durchschnittswert mindestens 1, doch vorzugsweise nicht höher als 100 ist, R und $R^1$ jeweils eine Gruppe der Formel

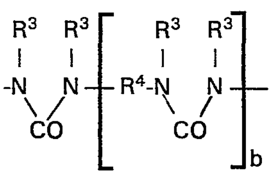

II

oder $-O-(OC)_c-R^5-(CO)_c-O-$, $R^2$ jeweils ein Wasserstoffatom oder eine Gruppe der Formel $-(CH_2NH)_d-COC(R^6)=CH_2$, mit der Massgabe, dass mindestens 1 und vorzugsweise mindestens 25% der $R^2$ Gruppen von einem Wasserstoffatom verschieden sind, $R^3$ jeweils eine Alkylgruppe mit 1 bis 4 Kohlenstoffatomen oder paarweise zusammen eine Gruppe der Formel $-CH_2CH_2-$, $-C(R^7R^8)CO-$, $CH_2CH-$, $-CH_2CH_2-$

$CH_3$

$CH_2-$, $-COCO-$, $-COCOCO-$ oder $-COC(OH)_2CO-$ und $R^4$ einen zweiwertigen aliphatischen, cycloaliphatischen oder araliphatischen Rest mit 1 bis 8 Kohlenstoffatomen, insbesondere eine Alkylengruppe mit 1 bis 6 Kohlenstoffatomen, darstellen, b, c und d je null oder 1 sind, $R^5$ eine geradkettige oder verzweigte aliphatische Gruppe mit 2 bis 20 Atomen, wie eine solche mit 2 bis 9 Kohlenstoffatomen, insbesondere eine gegebenenfalls durch eine oder mehrere Carbonyloxygruppen oder ein oder mehrere Äthersauerstoffatome unterbrochene Alkylengruppe oder auch, vorausgesetzt, dass c 1 ist, eine Gruppe der Formel

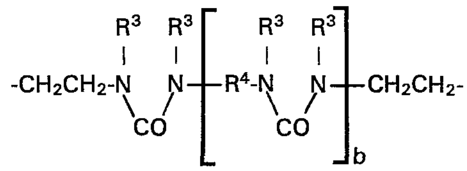

III

$R^6$ ein Wasserstoffatom oder eine Alkylgruppe mit 1 bis 4 Kohlenstoffatomen sowie $R^7$ und $R^8$ je ein Wasserstoffatom oder eine Methyl- oder Äthylgruppe bedeuten.

Die Harze der Formel I werden in zwei Stufen hergestellt. Bei der ersten handelt es sich um die Umsetzung eines Diepoxids der Formel IV

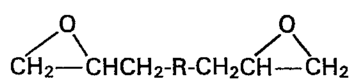

IV

mit einem Diol, einer Dicarbonsäure oder einem Heterocyclus der Formel V

$$H-R^1-H \quad V$$

zu einem vorverlängerten, linearen Diepoxid der Formel VI

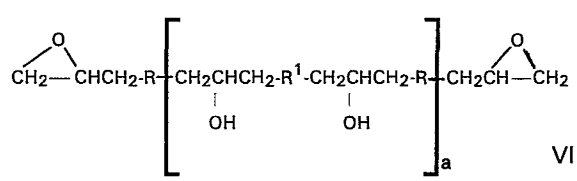

VI

In der zweiten Stufe werden einige oder sämtliche der abgebildeten sekundären Hydroxylgruppen mittels Umsetzung mit z.B. N-(Hydroxymethyl)-acrylamid oder Acryloylchlorid durch Gruppen der Formel $-O-(CH_2NH)_dCOC(R^6)=CH_2$ ersetzt.

In der britischen Patentschrift Nr. 1 367 207 hat die Anmelderin Polyacrylate N-heterocyclischer Verbindungen beschrieben. In einem der Beispiele ist ein Verfahren beschrieben, bei dem 1-Glycidyl-3-(2-glycidyloxy-n-propyl)-5,5-dimethylhydantoin (0,9 val)

mit Sebacinsäure (0,6 val) erhitzt wird, wobei sich ein Produkt vorwiegend der Struktur

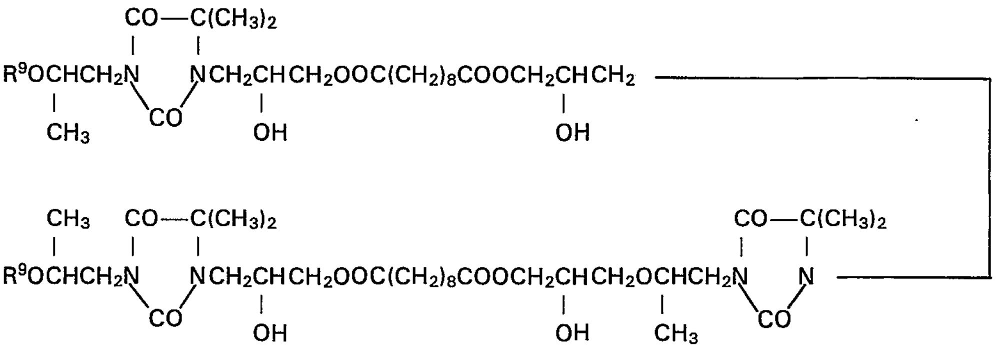

VII

worin $R^9$ jeweils eine Glycidylgruppe bedeutet, bildet.

Dieses Diepoxid erhitzt man dann mit Acrylsäure (0,3 val) unter Bildung eines Harzes, das in der Kälte hochviskos ist und dem hauptsächlich die Struktur VII, worin $R^9$ nun jeweils für eine 3-Acryloyloxy-2-hydroxypropylgruppe steht, zugeschrieben wird.

In der britischen Patentschrift Nr. 1 399 135 wurde von der Anmelderin die Polymerisation von Polyacrylaten wie solchen der Formel VII, worin $R^9$ jeweils eine 3-Acryloyloxy-2-hydroxypropylgruppe bedeutet, mittels ionisierender Strahlung beschrieben.

Es wurde nun gefunden, dass neuartige acryloyl- oder methacryloylhaltige Harze herstellbar sind, die die obigen Erfordernisse im wesentlichen erfüllen. Zwar sind sie nicht unbedingt voll in Wasser löslich, doch sind sie damit mischbar und lassen sich mit begrenzten Wassergehalten (z.B. von 5 bis 25 Gew.-%) leicht auftragen.

Ein Gegenstand dieser Erfindung sind demnach Harze, die bei Belichtung mit aktinischer Strahlung polymerisieren und harte, nicht-klebrige, chemisch widerstandsfähige Überzüge bilden, wobei diese Harze der Formel

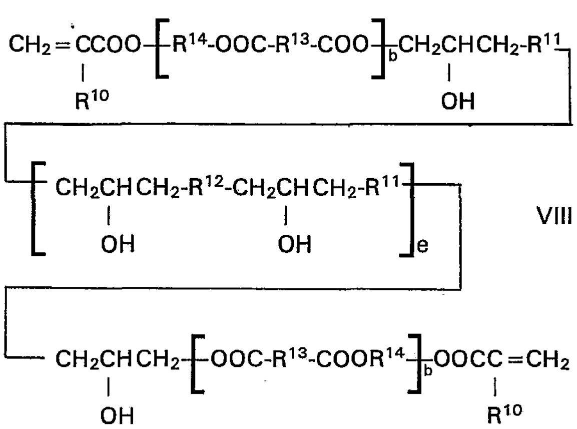

VIII

entsprechen, worin b null oder 1 und e eine Zahl vom Durchschnittswert mindestens 1 sind, $R^{10}$ jeweils für ein Wasserstoffatom oder eine Methylgruppe, $R^{11}$ jeweils für den organischen zweiwertigen Rest einer Verbindung mit zwei direkt an ein oder mehrere Sauerstoff-, Stickstoff- oder Schwefelatom(e) gebundenen Glycidylgruppen nach deren Wegnahme, $R^{12}$ jeweils für den zweiwertigen Rest eines zweiwertigen Alkohols, Phenols oder einer Verbindung mit zwei unter Amid- und Imidgruppen ausgewählten Gruppen nach Wegnahme von zwei endständigen, an ein oder mehrere Sauerstoff oder Stickstoffatom(e) gebundenen Wasserstoffatomen, $R^{13}$ jeweils für eine Alkylengruppe mit 1 bis 6 Kohlenstoffatomen, eine Alkenylengruppe mit 2 bis 10 Kohlenstoffatomen, eine Arylengruppe mit 6 bis 10 Kohlenstoffatomen oder eine Cycloalkylen- oder Cycloalkenylengruppe mit 5 bis 8 Kohlenstoffatomen und $R^{14}$ jeweils für eine zweiwertige aliphatische, cycloaliphatische oder araliphatische Gruppe mit 2 bis 8 Kohlenstoffatomen stehen, mit der Massgabe, dass mindestens 25% der Summe der (e + 1) $R^{11}$- und e $R^{12}$-Gruppen je eine Gruppe der Formel

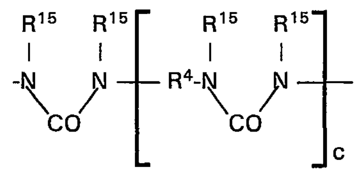

IX

darstellen, worin $R^4$ die oben angegebene Bedeutung hat, c null oder 1 ist und $R^{15}$ jeweils eine Alkylgruppe mit 1 bis 4 Kohlenstoffatomen oder paarweise zusammen eine Gruppe der Formel $-CH_2CH_2-$, $C(R^{16}R^{17})CO-$, $-CH_2CH-$, $-CH_2CH_2CH_2-$ oder $-COCO-$
|
$CH_3$

darstellen, wobei $R^{16}$ und $R^{17}$ je ein Wasserstoffatom oder eine geradkettige oder verzweigte Alkylgruppe mit bis zu 9 Kohlenstoffatomen bedeuten oder auch zusammen eine Tetramethylen-, Pentamethylen-, Methylpentamethylen- oder Hexamethylengruppe darstellen können.

Bevorzugt werden solche Harze der Formel VIII, worin e eine Zahl vom Durchschnittswert höchstens 10, insbesondere 1, 2 bis 5, ist.

Vorzugsweise bedeuten höchstens 75% der Summe der (e + 1) $R^{11}$ und e $R^{12}$-Gruppen eine Gruppe der Formel IX. Es wird angenommen, dass die Wasserverträglichkeit der Verbindungen der Formel VIII

der Gegenwart von Gruppen der Formel IX zuzuschreiben ist; besitzt ein zu hoher Teil der $R^{11}$- und $R^{12}$-Gruppen jedoch eine solche Konstitution, so kann das photopolymerisierte Produkt für einige Zwecke eine ungenügende Widerstandsfähigkeit gegen Wasser aufweisen. Es ist deshalb wünschenswert, dass mindestens 25% der Summe der Gruppen $R^{11}$ und $R^{12}$, falls diese nicht für eine Gruppe der Formel IX stehen, eine (gegebenenfalls in der Kette durch ein oder mehrere Äthersauerstoffatome unterbrochene) Oxyalkylenoxygruppe mit 2 bis 40 Kohlenstoffatomen oder eine Oxyarylenoxygruppe mit 6 bis 18 Kohlenstoffatomen darstellen. Ferner werden Verbindungen der Formel VIII bevorzugt, worin $R^{11}$ und $R^{12}$, falls sie nicht für eine Gruppe der Formel IX stehen, je eine Oxyalkylenoxygruppe bedeuten, deren Alkylenkomponente eine Kette mit 3 bis 6 aufeinanderfolgenden Kohlenstoffatomen oder eine durch ein oder mehrere Äthersauerstoffatome unterbrochene Kette von 4 bis 28 Kohlenstoffatomen, eine Oxyphenylenoxygruppe oder eine Gruppe der Formel

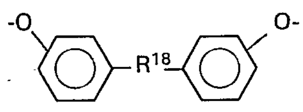

X

ist, worin $R^{18}$ für eine Kohlenstoff-Kohlenstoffbindung, ein Äthersauerstoffatom, eine Carbonylgruppe, eine Sulfonylgruppe, eine Methylengruppe oder eine Isopropylidengruppe steht.

Ist b 1, so stehen $R^{13}$ und $R^{14}$ vorzugsweise beide für Alkylengruppe mit 2 bis 6 Kohlenstoffatomen.

Besonders bevorzugt werden Harze, die Gruppen der Formel IX enthalten, worin jedes Paar $R^{15}$ eine Gruppe der Formel -C($R^{16}R^{17}$)CO- darstellt, wobei $R^{16}$ eine Methyl-, Äthyl-, n-Propyl-, n-Pentyl-, Neopentyl-, sek.-Amyl- oder 2-Äthylhexylgruppe und $R^{17}$ eine Methylgruppe oder $R^{16}$ und $R^{17}$ zusammen eine Pentamethylen- oder Hexamethylengruppe bedeuten.

Spezielle Beispiele für als $R^{11}$ und $R^{12}$ geeignete, zudem der Formel IX entsprechende Gruppen sind

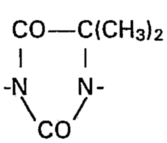

XI

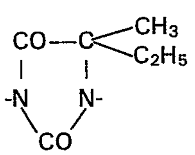

XII

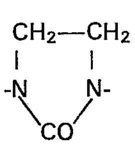

XIII

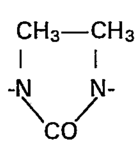

XIV

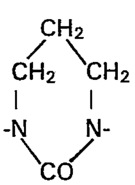

XV

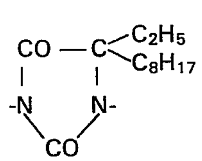

XVI

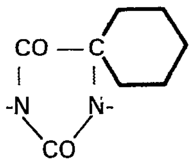

XVII

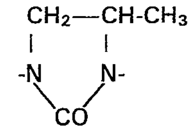

XVIII

und

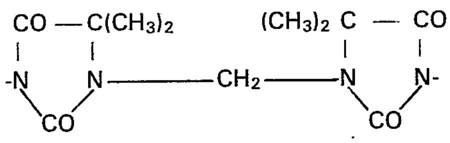

XIX

Die Gruppen der Formeln XI bis XIX stellen jeweils den Rest des 5,5-Dimethylhydantoins, 5-Äthyl-5-methylhydantoins, Imidazolin-2-ons, 1,3-Dimethylharnstoffs, Hexahydro-2H-pyrimidin-2-ons, 5-Methyl-5-(2-äthylhexyl)-hydantoins, 5,5-Pentamethylen-hydantoins, 4-Methylimidazolidin-2-ons bzw. 1,1′-Methylen-bis-(5,5-dimethylhydantoins) dar.

Spezielle Beispiele für geeignete Gruppen $R^{11}$ und $R^{12}$, die nicht zudem der Formel IX entsprechen, sind solche der Formel

$$-O(CH_2)_2O- \quad XX$$

$$-O(CH_2)_4O- \quad XXI$$

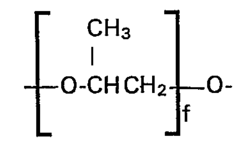

XXII

worin f eine Zahl vom Durchschnittswert 7,3 ist, sowie

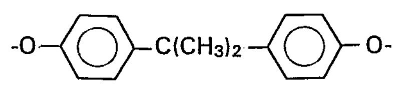

XXIII

Die Gruppen der Formeln XX bis XXIII stellen jeweils die Reste des Äthylenglykols, Butan-1,4-diols, eines Poly-(oxypropylen)-glykols vom Durchschnittsmolekulargewicht 425 bzw. 2,2-Bis-(4-hydroxyphenyl)-propans dar.

Harze der Formel VIII, in denen b null ist, lassen sich in zwei Stufen herstellen.

Dabei handelt es sich bei der ersten um die Umsetzung eines Diepoxids der Formel

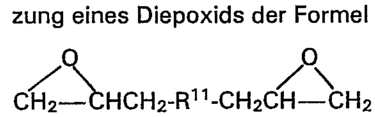

XXIV

mit einem zweiwertigen Alkohol, einem zweiwertigen Phenol, einer Dicarbonsäure oder einem Amid bzw. Amid-imid der Formel

$$H - R^{12} - H \quad XXV$$

wobei sich ein vorverlängertes, lineares Diepoxid der Formel

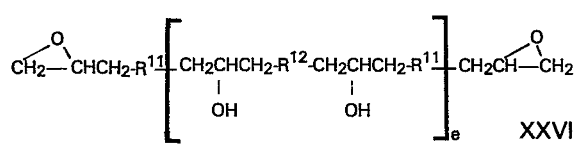

XXVI

worin e, $R^{11}$ und $R^{12}$ die oben angegebenen Bedeutungen haben, bildet.

Üblicherweise wird das Diepoxid der Formel XXIV mit der Verbindung der Formel XXV bei einer Temperatur im Bereich 120°-210°C, und insbesondere bei 140°-190°C, erhitzt. Die Reaktion lässt sich durch Zusatz geeigneter Katalysatoren beschleunigen. Beispiele für solche Katalysatoren sind Alkalihydroxyde wie Natriumhydroxyd, Alkalihalogenide wie Lithiumchlorid, Kaliumchlorid und Natriumchlorid, -bromid oder -fluorid, tertiäre Amine wie Triäthylamin, Tri-n-propylamin, N-Benzyldimethylamin, N,N'-Dimethylanilin und Triäthanolamin, quartäre Ammoniumbasen wie Benzyltrimethylammoniumhydroxyd, quartäre Ammoniumsalze wie Tetramethylammoniumchlorid, Tetraäthylammoniumchlorid, Benzyltrimethylammoniumchlorid, Benzyltrimethylammoniumacetat und Methyltriäthylammoniumchlorid, sowie Hydrazine mit einem tertiären Stickstoffatom, wie 1,1-Dimethylhydrazin, das auch in seiner quartärisierten Form eingesetzt werden kann. Je nach der Wahl der Ausgangsstoffe kann die Reaktion manchmal so schnell quantitativ verlaufen, dass keine Katalysatorzugabe nötig ist. Während die Ausgangsstoffe im allgemeinen bei Raumtemperatur miteinander vermischt und dann auf die Reaktionstemperatur gebracht werden, ist es bei miteinander sehr reaktiven Komponenten vorteilhaft, wenn man das Diepoxid der Formel XXIV zunächst für sich auf die erforderliche Reaktionstemperatur erhitzt und dann die übrigen Reaktionskomponenten allmählich in kleinen Portionen zusetzt. Das Fortschreiten der Reaktion bis zur Bildung eines Endprodukts mit einem definierten, im wesentlichen konstant bleibenden Epoxidgruppengehalt lässt sich durch Titrieren der Epoxidgruppen in während der Reaktion genommenen Proben verfolgen.

Derartige Vorverlängerungsreaktionen sind bekannt (siehe z.B. die oben erwähnte britische Patentschrift Nr. 1 521 933).

In der zweiten Stufe wird aus dem vorverlängerten Diepoxid der Formel XXVI durch Öffnung der endständigen Epoxidgruppen mittels Umsetzung mit Acrylsäure oder Methacrylsäure das wasserverdünnbare Harz der Formel VIII hergestellt.

Diese Reaktion erfolgt im allgemeinen bei einer Temperatur von 60° bis 150°C, insbesondere bei 100° bis 130°C, gegebenenfalls in Gegenwart eines inerten, polaren Lösungsmittels wie Chloroform. Vorzugsweise hat das Molverhältnis des vorverlängerten Diepoxids der Formel XXVI zu Acrylsäure oder Methacrylsäure einen solchen Wert, dass im wesentlichen sämtliche abgebildeten Glycidylgruppen in (Meth)acryloyl-2-hydroxypropylgruppen umgewandelt werden.

Vorzugsweise liegt ein Katalysator für die Ringöffnungsreaktion vor. Dieser Katalysator kann Natriumacetat oder vorzugsweise ein tertiäres Amin oder quartäres Ammoniumsalz wie eines der oben angeführten, oder ein Salz des dreiwertigen Chroms mit einer Alkansäure, wie Octansäure und 2-Äthylhexansäure, oder mit einer Alkensäure wie Acrylsäure sein.

Gewünschtenfalls kann man einen Radikalinhibitor wie Hydrochinon oder 2,6-Di-tert.-butyl-4-methylphenol mit zusetzen, um das Eintreten von Nebenreaktionen zu verringern. Solche Inhibitoren braucht man nach Beendigung der Reaktion nicht zu entfernen, da sie die Stabilität des Produkts aufrechterhalten, aber seine Polymerisation bei Belichtung mit aktinischer Strahlung nicht verhindern.

Harze der Formel VIII, in denen b 1 ist, lassen sich aus vorverlängerten, linearen Diepoxiden der Formel XXVI durch Öffnen der endständigen Epoxidgruppen bei der Umsetzung mit einer Dicarbonsäure der Formel

$$HOOC\text{-}R^{13}\text{-}COOH \qquad XXVII$$

worin $R^{13}$ die oben angegebene Bedeutung hat, oder mit einem Anhydrid einer Säure der Formel XXVII und nachfolgende Veresterung der so gebildeten endständigen Carbonsäuregruppen mit einem hydroxylgruppenhaltigen Ester der Acryl- oder Methacrylsäure, der Formel

$$CH_2{=}\underset{\displaystyle R^{10}}{\underset{|}{C}}COO\text{-}R^{14}OH \qquad XXVIII$$

worin $R^{10}$ und $R^{14}$ die oben angegebenen Bedeutungen haben, herstellen.

Die Ringöffnung der Epoxidgruppen erfolgt im allgemeinen unter denselben Bedingungen, wie oben für die Ringöffnung der Diepoxide der Formel XXVI mit Acryl- oder Methacrylsäure beschrieben, d.h. bei einer Temperatur von 60-150°C in Gegenwart eines Katalysators und gegebenenfalls eines Radikalinhibitors.

Die Veresterung mit einem Hydroxyester der Formel XXVIII erfolgt unter herkömmlichen Bedingungen, insbesondere durch Erhitzen auf 60° bis 150°C, speziell bei 100° bis 130°C, in Abwesenheit eines Lösungsmittels oder in einem inerten, vorzugsweise mit Wasser nicht mischbaren Lösungsmittel sowie gegebenenfalls in Gegenwart eines wasserabspaltenden Mittels. Gewünschtenfalls kann man diese beiden Stufen als Einstufenreaktion durchführen, indem man sämtliche Reaktionspartner in einem einzigen Behälter zusammenbringt und auf die gewünschte Temperatur erhitzt.

Gegenstand dieser Erfindung ist demnach weiterhin ein Verfahren zur Herstellung photopolymerisierbarer Harze der Formel VIII, worin b null ist, welches darin besteht, dass man die bezeichneten Epoxidgruppen in einem vorverlängerten Diepoxid der Formel XXVI mit Acryl- oder Methacrylsäure umsetzt, sowie ein Verfahren zur Herstellung photopolymerisierbarer Harze der Formel VIII, worin b 1 ist, welches darin besteht, dass man ein solches vorverlängertes Diepoxid mit einer Dicarbonsäure der Formel XXVII oder deren Anhydrid zusammen mit einem Hydroxyalkylester der Formel XXVIII umsetzt.

Eine Schicht des Harzes lässt sich durch Beschichtung des Trägers mit einem Harz, das mit Wasser gemischt ist, aufbringen, wobei man die Schicht beispielsweise durch Tauchen, Aufschleudern (bzw. Wirbelauftrag, d.h. ein Verfahren, bei dem das Material auf einen Träger aufgelegt wird, der dann hochtourig rotiert wird, um das Material darüber

zu verteilen), Aufsprühen oder Walzenantrag aufbringt.

Gegenstand der Erfindung ist ferner ein Träger aus beispielsweise Aluminium, Stahl oder einem anderen Metall, Papier oder Karton, der eine Schicht eines Harzes der Formel VIII trägt, sowie ein auf seiner Oberfläche ein solches, durch Belichtung mit aktinischer Strahlung polymerisiertes Harz tragendes Substrat. Ein weiterer Gegenstand ist ein Verfahren zum Polymerisieren eines solchen Harzes, welches darin besteht, dass man eine Schicht des Harzes auf einem Träger aktinischer Strahlung aussetzt.

Bei der Polymerisation der erfindungsgemässen Harze verwendet man vorzugsweise aktinische Strahlung einer Wellenlänge von 200 bis 600 nm.

Vorzugsweise erfolgt die Belichtung des Harzes mit aktinischer Strahlung in Gegenwart eines Photosensibilisators, wie einem Chinon, einem Diphenylcarbinol, 5-Nitroacenaphthen, einem 2-substituierten Thioxanthon, einem Diphenylmethan, einem $\alpha$-Halogenoacetophenon wie p-tert.-Butylphenyl-trichlormethylketon, einem Photoredoxkatalysator wie einem Gemisch aus einem Phenothiazinfarbstoff (z.B. Methylenblau) oder einem substituierten Chinoxalin mit einem Elektronendonatorreduktionsmittel wie einer Sulfinsäure oder deren Salz, einem Phosphin oder Arsin oder Thioharnstoff, einem Benzophenon, einem Benzildialkylketal wie Benzildimethylketal (d.h. $\alpha$-Methoxybenzoinmethyläther), Benzoin, einem Benzoinalkyläther oder einem O-Alkoxycarbonylderivat eines Oxims des Benzils oder 1-Phenylpropan-1,2-dions, wie Benzil-(O-äth-oxycarbonyl)-$\alpha$-monoxim und 1-Phenylpropan-1,2-dion-2-(O-äthoxycarbonyl)-oxim. Bevorzugte Sensibilisatoren sind Michlers Keton [d.h. 4,4'-Bis-(dimethylamino)-benzophenon], Benzoin-n-butyläther sowie Gemische dieser beiden, Metallsalze der 2-(m- oder p-Methoxyphenyl)-chinoxalin-(6'- oder -7'-sulfonsäure im Gemisch mit einem Metallsalz der Toluol-p-sulfinsäure, 1-Phenylpropan-1,2-dion-2-(O-äthoxycarbonyl)-oxim, Benzildimethylketal und Gemische dieser beiden, sowie 2-Chlorthioxanthon und dessen Gemische mit Benzildimethylketal. Üblicherweise werden 0,1 bis 20% und vorzugsweise 0,5 bis 15 Gew.-% Sensibilisator, berechnet auf das Gewicht des photopolymerisierbaren Harzes, eingesetzt.

Das Harz soll auf den Träger in einer Dicke von etwa 1 bis 250 $\mu$m aufgebracht werden. Falls nicht übermässige Mengen Wasser in der Beschichtung vorhanden sind, ist Trocknen unnötig; restliches Wasser im Film stört im allgemeinen die Photopolymerisation nicht, insbesondere wenn das Substrat relativ wasseraufsaugend ist, z.B. Pappe.

Geeignete aktinische Strahlungsquellen sind unter anderem Kohlelichtbögen, Quecksilberdampflichtbögen, Leuchtröhren mit Ultraviolettes Licht aussendenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung eines Harzes erforderliche Zeit hängt von verschiedenen Faktoren ab, unter anderem beispielsweise dem einzelnen verwendeten Harz, der Dicke der Beschichtung, der Art der Lichtquelle und deren Abstand von der Beschichtung, doch lässt sich dies leicht durch Serienversuche ermitteln.

Die nachfolgenden Beispiele erläutern die Erfindung. Die Epoxidgehalte werden durch Titration mit 0,1n-Perchlorsäurelösung in Eisessig in Gegenwart von überschüssigem Tetraäthylammoniumbromid mit Kristallviolett als Indikator bestimmt. Teile und Prozentangaben sind stets Gewichtsteile und Gewichtsprozente.

*Beispiel 1*

Man rührt ein Gemisch aus N,N'-Diglycidyl-5,5-dimethylhydantoin (Epoxidgehalt 7,88 val/kg, 50 g) und 1,4-Butandiol (12 g), nach Zusatz von Chrom-III-trisoctanoat (0,075 g) als Katalysator für die nachfolgende Umsetzung mit Acrylsäure, 5 Stunden lang bei 190°C, wonach der Epoxidgehalt des Gemischs auf 2,35 val/kg gefallen ist. Dann gibt man Acrylsäure (10,2 g) und 2,6-Di-t-butyl-4-methylphenol (0,14 g) bei 100°C zu dem vorverlängerten Harz. Das so erhaltene Gemisch wird 6 Stunden bei 100° bis 105°C gerührt, wonach sein Epoxidgehalt auf einen vernachlässigbar kleinen Wert gefallen ist. Zur Verdünnung versetzt man das Harz mit Wasser (8 g). Die entstandene Lösung besitzt eine Viskosität von 22 Pa.s bei 25°C.

Das Produkt entspricht im wesentlichen der Formel VIII, worin b null ist, e einen Durchschnittswert von 2,0 aufweist sowie $R^{10}$ jeweils ein Wasserstoffatom, $R^{11}$ jeweils eine Gruppe der Formel XI und $R^{12}$ jeweils eine Gruppe der Formel XXI bedeuten.

Man löst 1-Phenyl-1,2-propandion-2-(O-äthoxycarbonyl)-oxim (0,02 g) und Bezildimethylketal (0,02 g) in 2 g der Lösung. Man zieht einen 4 $\mu$m dicken Film der sensibilisierten Lösung auf 0,33 mm dicken Karton auf und belichtet mit UV-Strahlung durch einmaliges Durchführen durch einen «Minicure»-Apparat (Primarc Ltd., Stoke Row, bei Henleyon-Thames, England), der zwei Mitteldruckquecksilberbogenlampen (80 W pro cm) aufweist und mit einer Bandgeschwindigkeit von 60 Metern pro Minute läuft. Der gehärtete Überzug ist klebfrei und hochbiegsam: er genügt der Normprüfung auf Lösungsmittelbeständigkeit, indem er 20maligem Reiben mit einem in Äthylmethylketon bzw. Wasser getränkten Wattebausch jeweils widersteht.

*Beispiel 2*

Man rührt ein Gemisch aus N,N'-Diglycidyl-5,5-dimethylhydantoin (Epoxidgehalt 7,88 val/kg, 41,9 g), Bisphenol-A-diglycidyläther (Epoxidgehalt 5,2 val/kg, 12,0 g) und Chrom-III-trisoctanoat (0,075 g) enthaltendem 1,4-Butandiol (12,0 g) 5 Stunden bei 185°C, wonach der Epoxidgehalt des Gemischs 2,38 val/kg beträgt. Dann gibt man Acrylsäure (10,7 g) und 2,6-Di-t-butyl-4-methylphenol (0,14 g) dazu und rührt das Gemisch wie in Beispiel 1, jedoch 7 Stunden lang, zu welcher Zeit sein Epoxidgehalt auf einen vernachlässigbar kleinen Wert gefallen ist. Zur Verdünnung versetzt man das Harz mit Wasser (12 g). Die Lösung besitzt eine Viskosität von 15 Pa.s bei 25°C.

Das Produkt entspricht im wesentlichen der Formel VIII, worin b null ist, $R^{10}$ jeweils ein Wasserstoff-

atom bedeutet, einige der Gruppen $R^{11}$ der Formel XI und der Rest der Formel XXIII sowie die Gruppen $R^{12}$ der Formel XXI entsprechen.

Man stellt eine sensibilisierte Lösung her, zieht einen 4 $\mu$m dicken Film auf Karton auf und bestrahlt wie in Beispiel 1 beschrieben. Der bestrahlte Film ist klebfrei und hochbiegsam und genügt den organischen Lösungsmittel- und Wasserbeständigkeitsprüfungen gemäss Beispiel 1.

*Beispiel 3*

Man rührt ein Gemisch aus N,N'-Diglycidyl-5,5-dimethylhydantoin (Epoxidgehalt 7,88 val/kg, 25 g), Bisphenol-A-diglycidyläther (Epoxidgehalt 5,2 val/kg, 25 g) und Chrom-III-trisoctanoat (0,075 g) enthaltendem 1,4-Butandiol (8,5 g) $6^1/_2$ Stunden bei 185°C, zu welcher Zeit der Epoxidgehalt des Gemischs 2,55 val/kg beträgt.

Man gibt Acrylsäure (10,7 g) und 2,6-Di-t-butyl-4-methylphenol (0,14 g) dazu und rührt das Gemisch wie in Beispiel 2 7 Stunden lang, wonach sein Epoxidgehalt vernachlässigbar ist. Zur Verdünnung versetzt man das Harz mit Wasser (11,3 g).

Das Produkt entspricht im wesentlichen der Formel VII, worin b null ist, $R^{10}$ jeweils ein Wasserstoffatom bedeutet, einige der Gruppen $R^{11}$ der Formel XI und der Rest der Formel XXIII sowie die Gruppen $R^{12}$ der Formel XXI entsprechen.

Man stellt eine sensibilisierte Lösung her und zieht einen 4 $\mu$m dicken Film dieser auf Karton auf und bestrahlt wie in Beispiel 1 beschrieben. Der bestrahlte Film ist klebfrei und hochbiegsam, und er genügt den organischen Lösungsmittel- und Wasserbeständigkeitsprüfungen gemäss Beispiel 1.

*Beispiel 4*

Man rührt ein Gemisch aus N,N'-Diglycidyl-5,5-dimethylhydantoin (Epoxidgehalt 7,83 val/kg, 250 g), Diglycidyläther eines Polyoxypropylenglykols vom Durchschnittsmolekulargewicht 425 (Epoxidgehalt 2,81 val/kg, 750 g), Bisphenol A (150 g) und Natriumhydroxyd (0,65 g) 5 Stunden bei 165°C, zu welcher Zeit der Epoxidgehalt des Gemischs 2,27 val/kg beträgt. Man gibt Acrylsäure (184 g), 2,6-Di-t-butyl-4-methylphenol (2,6 g) und Chrom-III-trisoctanoat (1,6 g) zu dem Harz bei 120°C. Das Gemisch wird 11 Stunden bei 110°C bis 120°C gerührt, wonach sein Epoxidgehalt vernachlässigbar ist. Man versetzt das Harz mit Wasser (70 g) unter Bildung einer Lösung mit einer Viskosität von 6,1 Pa.s bei 25°C.

Das Produkt entspricht im wesentlichen der Formel VIII, worin b null ist, $R^{10}$ jeweils ein Wasserstoffatom bedeutet, einige der Gruppen $R^{11}$ der Formel XI und der Rest der Formel XXIII sowie die Gruppen $R^{12}$ der Formel XXII entsprechen.

Benzildimethylketal (0,4 g) wird in 19,6 g der Lösung aufgelöst. Man zieht einen 4 $\mu$m dicken Film der sensibilisierten Lösung auf Karton auf und bestrahlt wie in Beispiel 1 beschrieben. Der gehärtete Überzug ist klebfrei und hochbiegsam; er widersteht 10maligem Reiben mit einem in Äthylmethylketon getränkten Wattebausch sowie 20maligem Reiben mit einem in Wasser getränkten Wattebausch.

Ähnliche Ergebnisse erhält man mit einem Produkt aus einem Harz, bei dem 2-Phenylimidazol anstelle von Natriumhydroxyd als Vorverlängerungskatalysator verwendet wurde.

*Beispiel 5*

Man rührt ein Gemisch aus N,N'-Diglycidyl-5,5-dimethylhydantoin (Epoxidgehalt 7,83 val/kg, 250 g), Diglycidyläther eines Polyoxypropylenglykols vom Durchschnittsmolekulargewicht 425 (Epoxidgehalt 8,81 val/kg, 500 g), Bisphenol-A-diglycidyläther (Epoxidgehalt 5,31 val/kg, 250 g), Bisphenol A (202 g) und Natriumhydroxyd (0,64 g) $5^1/_2$ Stunden bei 165°C, zu welcher Zeit der Epoxidgehalt 2,44 val/kg beträgt, Acrylsäure (200 g), 2,6-Di-t-butyl-4-methylphenol (2,8 g) und Chrom-III-trisoctanoat (1,8 g) werden dem Harz bei 110°C zugesetzt, und das Gemisch wird 7 Stunden bei 105° bis 110°C gerührt, wonach dessen Epoxidgehalt vernachlässigbar ist (unter 0,1 val/kg). Zum Verdünnen versetzt man das Harz mit Wasser (155 g), wobei sich eine Lösung mit einer Viskosität von 25,3 Pa.s bei 25°C bildet.

Das Produkt entspricht im wesentlichen der Formel VIII, worin b null ist, $R^{10}$ jeweils ein Wasserstoffatom bedeutet, einige Gruppen $R^{11}$ der Formel XI, einige der Formel XXII und der Rest der Formel XXIII sowie die Gruppen $R^{12}$ ebenfalls der Formel XXIII entsprechen.

Man stellt wie in Beispiel 4 eine sensibilisierte Lösung her und zieht einen 4 $\mu$m dicken Film auf Karton auf und belichtet mit UV-Strahlung gemäss Beispiel 1. Der gehärtete Überzug ist klebfrei und hochbiegsam, und er genügt den organischen Lösungsmittel- und Wasserbeständigkeitsprüfungen gemäss Beispiel 1.

*Beispiel 6*

Man gibt 5,5-Pentamethylenhydantoin (16,2 g) portionsweise unter Rühren zu einem Gemisch aus 1,4-Butandioldiglycidyläther (Epoxidgehalt 8,6 val/kg, 36,5 g) und N-Phenylimidazol (0,02 g), wobei man die Temperatur bei 120-130° hält. nach beendeter Zugabe wird das Gemisch $1^1/_2$ Stunden bei 155° gerührt, zu welcher Zeit sein Epoxidgehalt auf 2,47 val/kg gefallen ist. Bei 100°C gibt man Acrylsäure (9,2 g) und 2,6-Di-t-butyl-4-methylphenol (0,1 g) dazu. Das Gemisch wird 5 Stunden bei 100 bis 105° gerührt, wonach dessen Epoxidgehalt auf einen vernachlässigbar kleinen Wert gefallen ist. Zum Verdünnen des Harzes versetzt man mit Wasser (10,5 g). Die entstandene Lösung besitzt eine Viskosität von 12,6 g Pa.s bei 25°.

Das Produkt entspricht im wesentlichen der Formel VIII, worin b null ist, e einen Durchschnittswert von 1, 7 aufweist, $R^{10}$ jeweils ein Wasserstoffatom, $R^{11}$ jeweils eine Gruppe der Formel XXI und $R^{12}$ jeweils eine Gruppe der Formel XVII bedeuten.

Man löst 1-Phenyl-1,2-propandion-2-(O-äthoxycarbonyl)-oxim (0,2 g) und Benzildimethylketal (0,2 g) in 20 g der obigen Lösung. man zieht einen 4 $\mu$m dicken Film der sensibilisierten Lösung auf Karton auf und bestrahlt wie in Beispiel 1 beschrieben. Der bestrahlte Film ist klebfrei und hochbiegsam, und er genügt den organischen Lösungsmittel- und Wasserbeständigkeitssprüfungen gemäss Beispiel 1.

*Beispiel 7*

Man gibt Adipinsäure (13,9 g) portionsweise unter Rühren zu einem Gemisch aus N,N'-Diglycidyl-5,5--dimethylhydantoin (Epoxidgehalt 7,8 val/kg, 40 g) und N-Phenylimidazol (0,02 g), wobei man die Temperatur zwischen 120 und 130° hält. Nach beendeter Zugabe rührt man das Gemisch 1 Stunde bei 140°C, zu welcher Zeit dessen Epoxidgehalt auf 2,1 val/kg gefallen ist. Bei 100° gibt man Acrylsäure (8,1 g) und 2,6-Di-t-butyl-4-methylphenol (0,1 g) dazu und rührt das Gemisch $4^1/_2$ Stunden bei 100-105°, wonach dessen Epoxidgehalt auf einen vernachlässigbar kleinen Wert gefallen ist. Man setzt genügend Wasser zu, damit die entstandene Lösung 20% Wasser enthält und eine Viskosität von 4,3 Pa.s bei 25° aufweist.

Das Produkt entspricht im wesentlichen der Formel VIII, worin b null ist, e einen Durchschnittswert von 2,0 aufweist, $R^{10}$ jeweils ein Wasserstoffatom, $R^{11}$ Adipoyl und $R^{12}$ jeweils eine Gruppe der Formel XI bedeuten.

Man stellt wie in Beispiel 6 eine sensibilisierte Lösung her und zieht einen 4 µm dicken Film der sensibilisierten Lösung auf Karton auf und bestrahlt wie in Beispiel 1 beschrieben. Der bestrahlte Film ist klebfrei und hochbiegsam, und er genügt den organischen Lösungsmittel- und Wasserbeständigkeitsprüfungen gemäss Beispiel 1.

*Beispiel 8*

Man erhitzt ein Gemisch aus Diglycidylhexahydrophthalat (Epoxidgehalt 6,4 val/kg, 41,2 g) und Tetramethylammoniumchlorid (0,1 g) auf 100°C und gibt im Verlauf 1 Stunde 5,5-Dimethylhydantoin (10,2 g) portionsweise dazu. Dann rührt man 4 Stunden bei 100°C, wonach der Epoxidgehalt auf 2,45 val/kg gefallen ist.

In einem getrennten Gefäss verührt man Bernsteinsäureanhydrid (30 g), 2-Hydroxyäthylacrylat (34,2 g), Tetramethylammoniumchlorid (0,2 g) und 2,6-Di-t-butyl-4-methylphenol (0,15 g) und erhitzt 3 Stunden auf 90°C. Nach dem Abkühlen erhält man 3-(2-Acryloyläthoxycarbonyl)-propionsäure. Dieses Produkt (27,2 g) wird mit 2,6-Di-t-butyl--4-methylphenol (0,1 g) vermischt und im Verlauf 1 Stunde bei 100°C dem vorverlängerten Harz zusetzt. Dann rührt man das Gemisch noch $4^1/_2$ Stunden bei 100°C, wonach dessen Epoxidgehalt auf einen vernachlässigbar kleinen Wert gefallen ist.

Das Produkt entspricht im wesentlichen der Formel VIII, worin b 1 und e 1 sind und $R^{10}$ jeweils Wasserstoff, $R^{11}$ Hexahydrophthaloyl, $R^{12}$ eine Gruppe der Formel XI sowie $R^{13}$ und $R^{14}$ je Äthylen bedeuten.

Man vermischt dieses Produkt (15 g) mit Wasser (5 g) und versetzt mit Benzildimethylketal (0,2 g) und 2-Chlorthioxanthon (0,2 g). Man zieht einen 6 µm dicken Film auf Karton auf und bestrahlt 1 bis 2 Sekunden unter einer 80 W pro cm-Mitteldruckquecksilberlampe im Abstand von 25 cm.

Der bestrahlte Überzug ist klebfrei und widersteht 2maligem Reiben mit einem in Äthylenmethylketon getränkten Wattebausch und 5maligem Reiben mit einem in Wasser getränkten Wattebausch.

*Beispiel 9*

Man erhitzt ein Gemisch aus N,N'-Diglycidyl-5,5--dimethylhydantoin (Epoxidgehalt 7,88 val/kg, 32 g), tetramethylammoniumchlorid (0,05 g) und Xylol (43 g) auf 120°C und gibt portionsweise 1,3-Dimethylharnstoff (11,0 g) dazu. Man rührt $4^3/_4$ Stunden bei 120°C, gibt noch weitere 0,05 g Tetramethylammoniumchlorid dazu und rührt das Gemisch $2^1/_2$ Stunden bei 120°C, zu welcher Zeit dessen Epoxidgehalt auf 2,25 val/kg gefallen ist.

Man lässt das Produkt auf 100°C abkühlen, tropft im Verlauf 1 Stunden ein Gemisch aus Methacrylsäure (5,36 g) und 2,6-Di-t-butyl-4-methylphenol (0,15 g) dazu und rührt dann noch 6 Stunden bei 100°C. Das Xylol wird bei vermindertem Druck abgedampft; das Produkt besitzt einen Epoxidgehalt von 0,82 val/kg.

Dieses Produkt (6 g) vermischt man mit Wasser (2 g), 1-Phenyl-1,2-propandion-2-(O-äthoxycarbonyl)-oxim (0,08 g) und Benzildimethylketal (0,08 g). Man zieht einen 6 µm dicken Film der sensibilisierten Lösung auf 0,33 mm dicken Karton auf und bestrahlt 5 Sekunden unter einer 80 W pro cm-Mitteldruckquecksilberlampe im Abstand von 25 cm.

Der bestrahlte Überzug ist klebfrei und widersteht 3maligem Reiben mit einem in Äthylmethylketon getränkten Wattebausch sowie 2maligem Reiben mit einem in Wasser getränkten Wattebausch.

*Beispiel 10*

Man gibt 5,5-Dimethylhydantoin (77,4 g) portionsweise unter Rühren zu einem Gemisch aus 1,4-Butan-dioldiglycidyläther Epoxidgehalt 8,6 wal/kg, 200 g) und Tetramethylammoniumchlorid (0,25 g). Man erhitzt auf 120°C, wobei eine die Temperatur auf 230°C erhöhende, exotherme Reaktion einsetzt. Dann wird das Gemisch auf 100°C abgekühlt; es besitzt einen Epoxidgehalt von 2,2 val/kg. Man gibt 2,6-Di-t-butyl-4-methylphenol (0,44 g) und danach im Verlauf 1 Stunde Methacrylsäure (54,6 g) und 2,6-Di-t-butyl-4-methylphenol (0,88 g) dazu. Man erhitzt das Gemisch $3^1/_2$ Stunden auf 100°C, wonach dessen Epoxidgehalt auf 0,6 val/kg gefallen ist.

Dieses Produkt (10 Teile) mischt man mit 2 Teilen Wasser 0,1 Teil 2-Chlorthioxanthon und 0,1 Teil Benzildimethylketal und bringt eine 6 µm dicke Schicht der Zusammensetzung auf Karton auf. Die Schicht wird 10 Sekunden im Abstand von 25 cm mit einer 80 W pro cm-Mitteldruckquecksilberlampe bestrahlt; der Film ist klebfrei und widersteht 6maligem Reiben mit einem in Wasser getränkten Wattebausch.

**Patentansprüche**

1. Photopolymerisierbare Harze der Formel

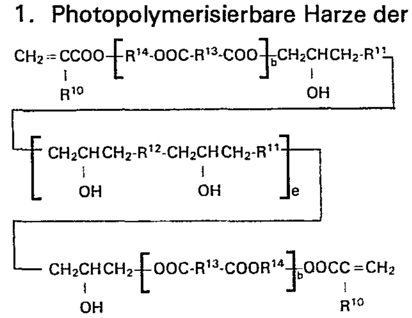

VIII

worin b null oder 1 und e eine Zahl vom Durchschnittswert mindestens 1 sind, $R^{10}$ jeweils für ein Wasserstoffatom oder eine Methylgruppe, $R^{11}$ jeweils für den organischen zweiwertigen Rest einer Verbindung mit zwei direkt an ein oder mehrere Sauerstoff-, Stickstoff- oder Schwefelatom(e) gebundenen Glycidylgruppen nach deren Wegnahme, $R^{12}$ jeweils für den zweiwertigen Rest eines zweiwertigen Alkohols, Phenols oder einer Verbindung mit zwei unter Amid- und Imidgruppen ausgewählten Gruppen nach Wegnahme von zwei endständigen, an ein oder mehrere Sauerstoff oder Stickstoffatom(e) gebundenen Wasserstoffatomen, $R^{13}$ jeweils für eine Alkylengruppe mit 1 bis 6 Kohlenstoffatomen, eine Alkenylengruppe mit 2 bis 10 Kohlenstoffatomen, eine Arylengruppe mit 6 bis 10 Kohlenstoffatomen oder eine Cycloalkylen- oder Cycloalkenylengruppe mit 5 bis 8 Kohlenstoffatomen und $R^{14}$ jeweils für eine zweiwertige aliphatische, cycloaliphatische oder araliphatische Gruppe mit 2 bis 8 Kohlenstoffatomen stehen, mit der Massgabe, dass mindestens 25% der Summe der (e+1) $R^{11}$- und e $R^{12}$-Gruppen je eine Gruppe der Formel

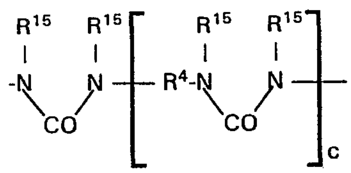
IX

darstellen, worin $R^4$ einen zweiwertigen aliphatischen oder araliphatischen Rest mit 1 bis 8 Kohlenstoffatomen bedeutet, c null oder 1 ist und $R^{15}$ jeweils eine Alkylgruppe mit 1 bis 4 Kohlenstoffatomen oder paarweise zusammen eine Gruppe der Formel $-CH_2CH_2-$, $C(R^{16}R^{17})CO-$, $-CH_2CH-$, $-CH_2CH(CH_3)CH_2-$ oder -COCO- darstellen, wobei $R^{16}$ und $R^{17}$ je ein Wasserstoffatom oder eine geradkettige oder verzweigte Alkylgruppe mit bis zu 9 Kohlenstoffatomen bedeuten oder auch zusammen eine Tetramethylen-, Pentamethylen-, Methylpentamethylen- oder Hexamethylengruppe darstellen können.

2. Harze nach Anspruch 1, dadurch gekennzeichnet, dass b null ist.

3. Harze nach Anspruch 1 oder 2, dadurch gekennzeichnet, dass e eine Zahl mit einem Durchschnittswert von höchstens 10 ist.

4. Harze nach einem der vorhergehenden Ansprüche, dadurch gekennzeichnet, dass höchstens 75% der Summe der (e+1) $R^{11}$- und e $R^{12}$-Gruppen eine Gruppe der Formel IX darstellen und der Rest der $R^{11}$- und $R^{12}$-Gruppen für eine (in der Kette gegebenenfalls durch ein oder mehrere Äthersauerstoffatome unterbrochene) Oxyalkylenoxygruppe mit 2 bis 40 Kohlenstoffatomen oder eine Oxyarylenoxygruppe mit 6 bis 18 Kohlenstoffatomen stehen.

5. Harze nach Anspruch 4, dadurch gekennzeichnet, dass die Alkylenkomponente dieser Oxyalkylenoxygruppe entweder eine Kette von 3 bis 6 aufeinanderfolgenden Kohlenstoffatomen oder eine durch ein oder mehrere Äthersauerstoffatome unterbrochene Kette von 4 bis 28 Kohlenstoffatomen enthält und als Oxyarylenoxygruppe entweder eine Oxyphenylenoxygruppe oder eine Gruppe der Formel

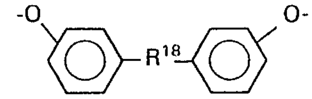
X

vorliegt, worin $R^{18}$ für eine Kohlenstoff-Kohlenstoffbindung, ein Äthersauerstoffatom, eine Carbonylgruppe, eine Sulfonylgruppe, eine Methylengruppe oder eine Isopropylidengruppe steht.

6. Verfahren, zur Herstellung von Harzen nach einem der Ansprüche 2 bis 5, worin b null ist, dadurch gekennzeichnet, dass man die bezeichneten Epoxidgruppen in einem vorverlängerten Diepoxid der Formel

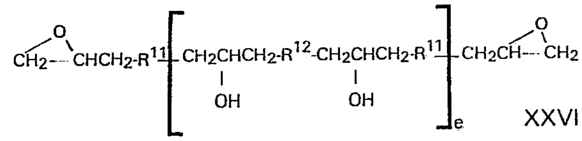
XXVI

mit Acrylsäure oder Methacrylsäure umsetzt, wobei e die in Anspruch 1 oder 3 sowie $R^{11}$ und $R^{12}$ die in einem der Ansprüche 1, 4 oder 5 angegebenen Bedeutungen haben.

7. Verfahren zur Herstellung von Harzen nach einem der Ansprüche 1 und 3 bis 5, worin b 1 ist, dadurch gekennzeichnet, dass man ein vorverlängertes Diepoxid der Formel

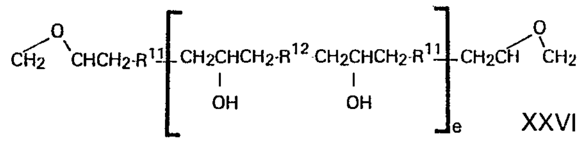
XXVI

mit einer Dicarbonsäure der Formel

$$HOOC\text{-}R^{13}\text{-}COOH \qquad XXVII$$

worin $R^{13}$ die in Anspruch 1 angegebene Bedeutung hat, oder dem Anhydrid einer solchen Säure der Formel XXVII umsetzt und anschliessend die so gebildeten endständigen Carbonsäuregruppen mit einem hydroxylgruppenhaltigen Ester der Acryl- oder Methacrylsäure, der Formel

$$CH_2{=}\underset{\displaystyle R^{10}}{\underset{|}{C}}COO\text{-}R^{14}OH \qquad XXVIII$$

worin $R^{10}$ und $R^{14}$ die in Anspruch 1 angegebenen Bedeutungen haben, verestert.

8. Verfahren zur Polymerisation einer auf einen Träger aufgebrachten photopolymerisierbaren Harzschicht, bei dem man die Harzschicht aktinischer Strahlung aussetzt, dadurch gekennzeichnet, dass die Harzschicht aus einem Harz nach einem der Ansprüche 1 bis 5 besteht.

9. Verfahren nach Anspruch 8, dadurch gekennzeichnet, dass das Harz mit Wasser gemischt auf den Träger aufgebracht wurde.

## Claims

1. A photopolymerisable resin of the formula

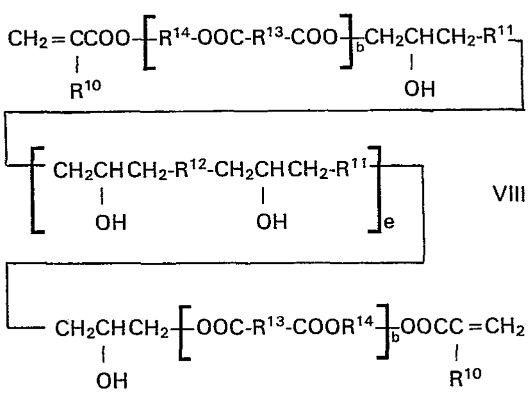

VIII

wherein b is zero or 1, e is a number of average value at least 1, each $R^{10}$ is a hydrogen atom or a methyl group, each $R^{11}$ is the organic divalent residue of a compound having two glycidyl groups directly attached to one or more oxygen, nitrogen, or sulfur atoms, after removal of the said two glycidyl groups, each $R^{12}$ is the divalent residue of a dihydric alcohol, of phenol, or of a compound containing two groups selected from amide groups and imide groups, after removal of two terminal hydrogen atoms attached to one or more oxygen or nitrogen atoms, each $R^{13}$ is an alkylene group of 1 to 6 carbon atoms, an alkenylene group of 2 to 10 carbon atoms, an arylene group of 6 to 10 carbon atoms, or a cycloalkylene or cycloalkenylene group of 5 to 8 carbon atoms, and each $R^{14}$ is a divalent aliphatic, cycloaliphatic, or araliphatic group of 2 to 8 carbon atoms, with the proviso that at least 25% of the total of each of the (e + 1) $R^{11}$ and e $R^{12}$ groups is a ground of the formula

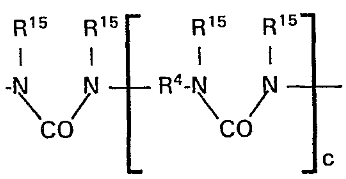

IX

wherein $R^4$ is a divalent aliphatic, cycloaliphatic radical of 1 to 8 carbon atoms, c is zero or 1, and each $R^{15}$ is an alkyl group of 1 to 4 carbon atoms or each pair of $R^{15}$ conjointly is a group of formula $-CH_2CH_2-$, $C(R^{16}R^{17})CO-$, $-CH_2CH-$ (with $CH_3$ on the CH), $-CH_2CH_2CH_2-$ or $-COCO-$

wherein each of $R^{16}$ and $R^{17}$ is a hydrogen,atom or a straight chain or branched alkyl group of up to 9 carbon atoms or $R^{16}$ and $R^{17}$ together may be tetramethylene, pentamethylene, methylpentamethylene, or hexamethylene.

2. A resin according to claim 1, wherein b is zero.

3. A resin according to either claim 1 or claim 2, wherein e is a number of average value of at most 10.

4. A resin according to any one of the preceding claims, wherein at most 75% of the total of the (e + 1) $R^{11}$ and e $R^{12}$ groups is a group of formula IX and the remaining $R^{11}$ and $R^{12}$ groups are an oxyalkyleneoxy group of 2 to 40 carbon atoms, an oxyalkyleneoxy group of 2 to 40 carbon atoms interrupted in the chain by one or more ether oxygen atoms, or an oxyaryleneoxy group of 6 to 18 carbon atoms.

5. A resin according to claim 4, wherein the alkylene component of the said oxyalkyleneoxy group contains either a chain of 3 to 6 consecutive carbon atoms or a chain of 4 to 28 carbon atoms which is interrupted by one or more ether oxygen atom, and the oxyaryleneoxy group is either a oxyphenyleneoxy group or a group of formula

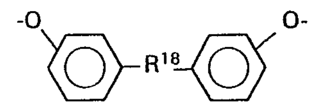

X

wherein $R^{18}$ is a carbon-carbon bond, an ether oxygen atom, a carbonyl group, a sulfonyl group, a methylene group, or an isopropylidene group.

6. A process for the preparation of a resin according to any one of claims 2 to 5, wherein b is zero, which process comprises reacting the indicated epoxide groups in an advanced diepoxide of formula

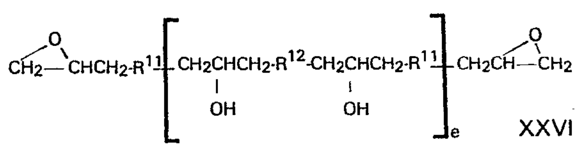

XXVI

wherein e is as defined in either claim 1 or claim 3 and $R^{11}$ and $R^{12}$ are as claimed in any one of claims 1, 4 or 5, with acrylic acid or methacrylic acid.

7. A process for the preparation of a resin according to any one of claims 1 and 3 to 5, wherein b is 1, which process comprises reacting an advanced diepoxide of formula

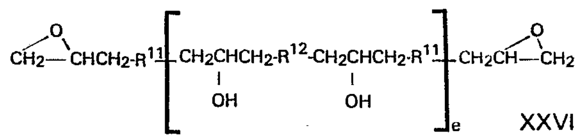

XXVI

with a dicarboxylic acid of formula

$$HOOC-R^{13}-COOH \qquad XXVII$$

wherein $R^{13}$ is as defined in claim 1, or with an anhydride of such an acid of formula XXVII and subsequently esterifying the thus formed terminal carboxylic acid groups with a hydroxyl groupcontaining ester having the formula

$$CH_2=CCOO-R^{14}OH \qquad XXVIII$$
|
$R^{10}$

wherein $R^{10}$ and $R^{14}$ are as defined in claim 1.

8. A process for polymerising a photopolymerisable resin layer applied to a support, by subjecting said resin layer to actinic radiation, wherein the resin layer comprises a resin according to any of claims 1 to 5.

9. A process according to claim 8, wherein the resin, in admixture with water, has been applied to the support.

**Revendications**

1. Résines photopolymérisables répondant à la formule VIII

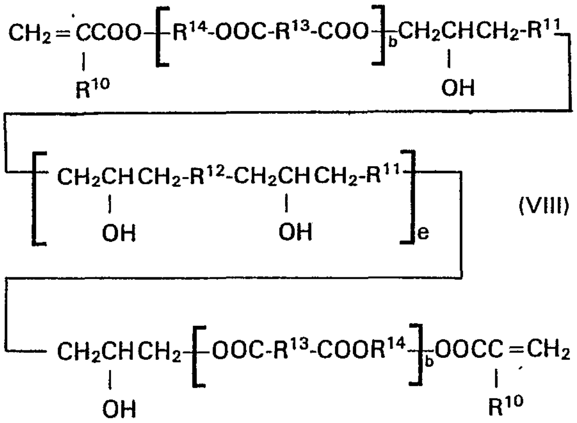

(VIII)

dans laquelle b est égal à 0 ou à 1, e représente un nombre dont la valeur moyenne est au moins égale à 1, les $R^{10}$ représentent chacun un atome d'hydrogène ou un radical méthyle, les $R^{11}$ représentent chacun le radical organique bivalent que l'on obtient en amputant de ses radicaux glycidyles un composé contenant deux radicaux glycidyles directement liés à un ou plusieurs atomes d'oxygène, d'azote ou de soufre, les $R^{12}$ représentent chacun le radical bivalent qui subsiste lorsque d'un diol, d'un biphénol ou d'un composé renfermant deux radicaux pris parmi les radicaux amides et imides on a enlevé deux atomes d'hydrogène terminaux liés à un ou plusieurs atomes d'oxygène ou d'azote, les $R^{13}$ représentent chacun un radical alkylène contenant de 1 à 6 atomes de carbone, un radical alcénylène contenant de 2 à 10 atomes de carbone, un radical arylène contenant de 6 à 10 atomes de carbone ou un radical cycloalkylène ou cycloalcénylène contenant de 5 à 8 atomes de carbone et les $R^{14}$ représentent chacun un radical bivalent aliphatique, cycloaliphatique ou araliphatique contenant de 2 à 8 atomes de carbone, avec la condition qu'au moins 25% de la somme des (e + 1) radicaux $R^{11}$ et des e radicaux $R^{12}$ représentent chacun un radical répondant à la formule IX

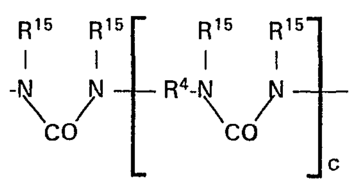

(IX)

dans laquelle $R^4$ représente un radical bivalent aliphatique, cycloaliphatique ou araliphatique contenant de 1 à 8 atomes de carbone, c est égal à 0 ou à 1 et les $R^{15}$ représentent chacun un radical alkyle contenant de 1 à 4 atomes de carbone ou représentent, associés deux à deux, un radical $-CH_2CH_2-$, $C(R^{16}R^{17})CO-$, $-CH_2CH(CH_3)-$, $-CH_2CH_2CH_2-$ ou $-COCO-$ où $R^{16}$ et $R^{17}$ peuvent représenter chacun un atome d'hydrogène ou un radical alkyle, linéaire ou ramifié, contenant au plus 9 atomes de carbone, ou encore forment ensemble un radical tétraméthylène, pentaméthylène, méthyl-pentaméthylène ou hexaméthylène.

2. Résines selon la revendication 1, caractérisées en ce que b est égal à 0.

3. Résines selon l'une des revendications 1 et 2, caractérisées en ce que e est un nombre ayant une valeur moyenne d'au plus 10.

4. Résines selon l'une quelconque des revendications précédentes, caractérisées en ce qu'au plus 75% de la somme des (e + 1) radicaux $R^{11}$ et des e radicaux $R^{12}$ représentent chacun un radical de formule IX, et les radicaux $R^{11}$ et $R^{12}$ restants représentent chacun un radical oxy-alkylène-oxy contenant de 2 à 40 atomes de carbone (éventuellement interrompus dans sa chaîne par un ou plusieurs atomes d'oxygène de fonction éther) ou un radical oxy-arylène-oxy contenant de 6 à 18 atomes de carbone.

5. Résines selon la revendication 4, caractérisées en ce que la partie alkylène du radical oxy-alkylène-oxy contient soit une chaîne de 3 à 6 atomes de carbone successifs, soit une chaîne de 4 à 28 atomes de carbone qui est interrompue par un ou plusieurs atomes d'oxygène de fonction éther, et le radical oxy-arylène-oxy est soit un radical oxy-phénylène-oxy, soit un radical répondant à la formule X

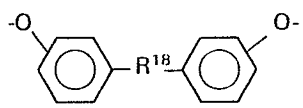

X

dans laquelle $R^{18}$ représente une liaison carbone-carbone, un atome d'oxygène de fonction éther, un radical carbonyle, un radical sulfonyle, un radical méthylène ou un radical isopropylidène.

6. Procédé pour préparer des résines conformes à l'une quelconque des revendications 2 à 5 et dans lesquelles b est égal à 0, procédé caractérisé en ce qu'on fait réagir les radicaux époxy représentés d'un diépoxyde pré-allongé répondant à la formule XXVI

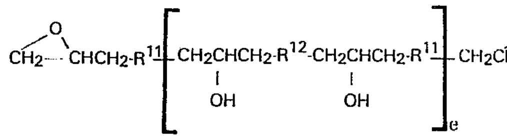

XXVI

dans laquelle e a la signification donnée à l'une des revendications 1 et 3, tandis que $R^{11}$ et $R^{12}$ ont les siginifications données à l'une quelconque des revendications 1, 4 et 5, avec l'acide acrylique ou l'acide méthacrylique.

7. Procédé pour préparer des résines conformes à l'une quelconque des revendications 1 et 3 à 5 et dans lesquelles b est égal à 1, procédé caractérisé en ce qu'on fait réagir un diépoxide pré-allongé de formule XXVI

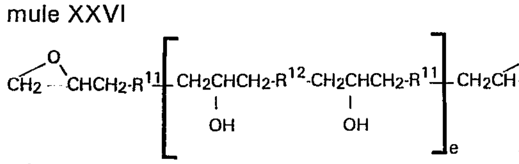

XXVI

avec un acide dicarboxylique répondant à la formule XXVII

$$HOOC\text{-}R^{13}\text{-}COOH \qquad XXVII$$

dans laquelle $R^{13}$ a la signification donnée à la revendication 1, ou avec l'anhydride d'un tel acide de formule XXVII, puis on estérifie les radicaux carboxy terminaux ainsi formés en utilisant pour cela un ester hydroxylé de l'acide acrylique ou de l'acide méthacrylique qui répond à la formule XXVIII

$$CH_2{=}\underset{\displaystyle R^{10}}{\underset{|}{C}}COO\text{-}R^{14}OH \qquad XXVIII$$

dans laquelle $R^{10}$ et $R^{14}$ ont les significations données à la revendication 1.

8. Procédé pour polymériser une couche de résine photopolymérisable appliquée sur un support, par exposition de celle-ci à un rayonnement actinique, procédé caractérisé en ce que la couche de résine est constituée d'une résine selon l'une quelconque des revendications 1 à 5.

9. Procédé selon la revendication 8, caractérisé en ce que la résine à été additionnée d'eau pour être appliquée sur le support.